# EUROPÄISCHE PATENTSCHRIFT

(11) **EP 0 954 876 B1**
(45) Veröffentlichungstag und Bekanntmachung des Hinweises auf die Patenterteilung: **16.04.2003**
(21) Anmeldenummer: 98907975.1
(22) Anmeldetag: 22.01.1998
(51) Int. Cl.: H01J 37/34

(54) **VERFAHREN UND EINRICHTUNG ZUM BETREIBEN VON MAGNETRONENTLADUNGEN**
PROCESS AND SYSTEM FOR OPERATING MAGNETRON DISCHARGES
PROCEDE ET SYSTEME D'EXPLOITATION DE DECHARGES DE MAGNETRONS

(30) Priorität: 23.01.1997 DE 19702187
(43) Veröffentlichungstag der Anmeldung: 10.11.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: GOEDICKE, Klaus, D-01307 Dresden (DE); WINKLER, Torsten, D-01454 Radeberg (DE); JUNGHÄHNEL, Michael, D-01324 Dresden (DE); FIETZKE, Fred, D-01127 Dresden (DE); KIRCHHOFF, Volker, D-01324 Dresden (DE); RESCHKE, Jonathan, D-01307 Dresden (DE)
(86) Internationale Anmeldenummer: EP9800340
(87) Internationale Veröffentlichungsnummer: WO98033201

(56) Entgegenhaltungen:
- EP-A- 0 692 550
- DE-C- 4 438 463
- US-A- 5 286 360
- US-A- 5 584 974

## Beschreibung

Die Erfindung betrifft ein Verfahren und eine zugehörige Einrichtung zum Betreiben von Magnetronentladungen. Magnetronentladungen finden einen breiten Einsatz in der Vakuumbeschichtungsstechnik. Das wichtigste Einsatzgebiet ist das Magnetronzerstäuben, auch Sputtern genannt, zur Abscheidung dünner Schichten aus Metallen, Legierungen oder reaktiv abgeschiedenen chemischen Verbindungen wie Oxiden oder Nitriden. Weiterhin dienen Magnetronentladungen beim plasmaaktivierten reaktiven Bedampfen zur Erzeugung des Plasmas. Ein weiteres Anwendungsgebiet ist die Erzeugung magnetronverstärkter Plasmen für die Substratvorbehandlung vor der Vakuumbeschichtung. Wichtige Einsatzgebiete sind die Herstellung optisch wirksamer Schichten in der Glasindustrie, die Herstellung dekorativer, verschleißmindemder und harter Schichten in der Werkzeugindustrie und im Maschinenbau, die Herstellung von Barriereschichten in der Verpackungsindustrie und die Herstellung von isolierenden Schichten für die Elektronik und für Speichermedien.

Die Anwendung von Magnetronentladungen in Sputterverfahren zur Abscheidung elektrisch gut leitender Schichten wird im technischen Maßstab sicher beherrscht. Elektrisch isolierende Schichten können durch Anwendung von Hochfrequenz-Sputtern abgeschieden werden. Wegen zahlreicher Nachteile hat dieses Verfahren jedoch nur begrenzte technische Verbreitung gefunden. Bei der reaktiven Abscheidung elektrisch isolierender Schichten durch Gleichstrom-Sputtern metallischer Targets in einem Gasgemisch, welches neben Edelgas auch Anteile reaktiver Gase wie Sauerstoff oder Stickstoff enthält, treten zwei grundsätzliche Schwierigkeiten auf. Eine Schwierigkeit ist die mangelnde Langzeitstabilitiät der Entladung: Durch Abscheidung isolierender Schichten im gesamten Prozeßraum bedecken sich auch die als Anode wirkenden Elektrodenflächen, so daß die Impedanz der Magnetronentladung mit wachsender Prozeßzeit stetig zunimmt. Das führt zu mangelhafter Konstanz der Prozeßparameter, so daß die Entladung schließlich nicht mehr gezündet werden kann oder daß die technischen Parametergrenzen der Stromversorgungseinrichtung nicht mehr ausreichen. Die zweite Schwierigkeit ist das Auftreten von Bogenentladungen, die als "arcing" bezeichnet werden und z.T. auch beim Betreiben nichtreaktiver Magnetronentladungen auftreten. Diese Erscheinung wird durch elektrische Aufladung isolierender Schichten auf den als Katode geschalteten Targets verursacht. Als Folge dieser Aufladungen treten elektrische Durchbrüche in Form der genannten Bogenentladungen auf, die Defekte in den Schichten und auf der Targetoberfläche hervorrufen und eine ausreichende Prozeßstabilität verhindern. Das gilt insbesondere für reaktive Magnetronentladungen.

Es ist bekannt, die Beschichtung der Anode durch zweckmäßige geometrische Gestaltung wesentlich zu verzögern (DE 42 23 505). Dadurch wird die Langzeitstabilität der Magnetronentladungen verbessert und die nutzbare Prozeßzeit verlängert, jedoch wird das Problem im Grundsatz nicht gelöst.

Zur Vermeidung der Auswirkungen des "arcing" sind zahlreiche passive und aktive Beschaltungen der Magnetronentladungsanordnungen bekannt. Weiterhin ist bekannt, elektrische Glimmentladungen oder Magnetronentladungen mit gepulstem Gleichstrom zu speisen (DE 37 00 633; DE 42 23 505). Damit wird der Energieinhalt auftretender Bogenentladungen begrenzt und der Entstehung von Bogenentladungen vorgebeugt. Es wurden verschiedene Schaltungen vorgeschlagen, die außer der pulsförmigen Einspeisung von Gleichstrom auch eine geringfügige Gegenspannung erzeugen (DE 41 27 317; DE 41 27 504; DE 42 39 218; DE 42 30 779; WO 93/12604). Solche Verfahren und Einrichtungen haben sich vorzugsweise für das nicht reaktive Sputtern elektrisch leitender Materialien in Edelgas oder das schwach reaktive Sputtern bewährt. Das Auftreten energiereicher Bogenentladungen kann damit wirksam verhindert werden. Jedoch lassen sich hochisolierende Schichten damit nicht stabil abscheiden, und das Problem der Bedeckung der als Anode wirkenden Elektrodenflächen ist weiterhin ungelöst.

Es ist weiterhin bekannt, zur reaktiven Abscheidung von dünnen Schichten Anordnungen mit zwei Magnetronquellen zu verwenden, die mit einer potentialfreien Wechselspannung betrieben werden und bei denen die Targets abwechselnd als Katode und Anode der Magnetronentladung wirken (DD 252 205; DE 38 02 852). Damit wird die Langzeitstabilität der Magnetronentladung auch in Gasgemischen, die neben Edelgas Bestandteile reaktiver Gase enthalten, erreicht. Als zweckmäßigste Frequenz der Wechselspannung hat sich der Bereich von etwa 10 kHz bis etwa 150 kHz erwiesen. Es werden Sinus- oder Rechteckspannungen verwendet.

Durch spezielle Beschaltungen der Magnetronentladungen, z.B. mittels L-C-Kombinationen, kann die Gefahr der Ausbildung von Bogenentladungen weiter verringert werden (US 5,303,139; DE 41 38 793; DE 42 04 999). Die optimale Dimensionierung solcher Beschaltungen erweist sich jedoch in der Praxis als außerordentlich schwierig, da die Bemessung der Bauelemente von der Frequenz und der Impedanz der Magnetronentladung abhängt. Jede Parameteränderung der Entladungen, z.B. Veränderungen des Targetmaterials, des Druckes, der Gaszusammensetzung usw., erfordert eine Veränderung bzw. Anpassung der Beschaltung. Auch bei Konstanz aller Parameter ändert sich in jedem Puls die Impedanz der Entladung von der Zündphase zur Brennphase, so daß die Optimierungsmöglichkeit der Beschaltung im Grundsatz begrenzt ist. Infolgedessen werden nur quantitative Verbesserungen durch die vorgeschlagenen Lösungswege erreicht. Die Energie auftretender Bögen wird als Verlustenergie in den Bauelementen der Beschaltung wirksam.

Um die Stromversorgungseinrichtung optimal an unterschiedliche Impedanzen der beiden Magnetronentladungen anzupassen, ist bekannt, die Energiezufuhr zeitlich gesteuert zu unterbrechen (DE 43 24 683). Nachteilig bei dieser Verfahrensweise ist, daß sich die Wirksamkeit der Energieeinspeisung verschlechtert.

Um die bekannte bipolare Energieeinspeisung in Magnetronanordnungen mit zwei oder mehr Elektroden zu verbessern, sind ein Verfahren und eine Schaltung bekannt, die Wechselstrompulse mit dem Charakter einer Stromquelle realisieren, d.h. in jedem Puls nach sehr kurzer Stromanstiegszeit einen konstanten Strom in die Magnetronentladung einspeisen (DE 44 38 463). Der Nachteil dieses Verfahrens besteht darin, daß es mit einer sehr hohen Belastung der verwendeten Halbleiter-Schaltelemente verbunden ist, so daß die Durchführung des Verfahrens gegenwärtig nur bis zu einer bestimmten Leistung der Magnetronentladung, die deutlich unter 20 kW liegt, technisch anwendbar ist. Aus diesem Grunde können Magnetronentladungen von z.B. 100 kW, wie sie zur Beschichtung von Architekturglas erforderlich sind, bisher nur mit Sinusgeneratoren gespeist werden. Die bereits genannten Schwierigkeiten, dabei den Energieinhalt möglicherweise noch auftretender Bogenentladungen und damit schädlicher Auswirkungen auf die Schichten zu begrenzen, sind nicht ausreichend zu beseitigen.

Der Erfindung liegt die Aufgabe zugrunde, ein Verfahren und eine Einrichtung zum Betreiben von Magnetronentladungen zu schaffen, welche die Energieeinspeisung in Magnetronentladungen mit mindestens zwei Magnetron-Elektroden verbessern.

Insbesondere soll auch die Einspeisung hoher Entladungsleistungen möglich sein und eine hohe Wirksamkeit der eingespeisten Leistung erreicht werden. Die Ausbildung von Bogenentladungen soll verhindert und der Ausbildung von Voraussetzungen zur Entstehung solcher Bögen soll vorbeugend entgegengewirkt werden. Das Verfahren und die zugehörige Einrichtung sollen auch geeignet sein, ein vorgegebenes Verhältnis der Entladungsleistungen an den Magnetron-Elektroden einzustellen, vorzugsweise ein Verhältnis 1:1, wenn die Impedanz der Magnetronentladungen der einzelnen Magnetron-Elektroden unterschiedlich groß ist.

Erfindungsgemäß wird die Aufgabe mit den Merkmalen der Patentansprüche 1, 9 und 10 gelöst. Weitere vorteilhafte Ausgestaltungen sind in den Ansprüchen 2 bis 8 und 11 beschrieben.

Das erfindungsgemäße Verfahren dient der Energieeinspeisung zum Betreiben von Magnetronentladungen mit mindestens zwei Magnetron-Elektroden, wobei mindestens eine Magnetron-Elektrode in einem Zeitabschnitt T₁ als Anode und mindestens eine Magnetron-Elektrode als Katode geschaltet wird. Die Energieeinspeisung erfolgt in diesem Zeitabschnitt T₁ pulsförmig mit einer Frequenz f₁=1/T₁ im Mittelfrequenzbereich, wobei eine begrenzte Anzahl n₁ von Gleichstrompulsen eingespeist wird. Nach dem Zeitabschnitt T₁ wird ein Polwechsel derart durchgeführt, daß mindestens eine andere Magnetron-Elektrode als Katode und mindestens eine andere Magnetron-Elektrode als Anode geschalten wird. In einem nun folgenden Zeitabschnitt T₂ wird die Energie als eine begrenzte Anzahl n₂ von Gleichstrompulsen mit einer Frequenz f₂=1/T₂, ebenfalls im Mittelfrequenzbereich, eingespeist. In diesem Zeitabschnitt T₂ erfolgt das Sputtern der Oberfläche der katodischen Magnetron-Elektrode, wobei nach dem Abtragen der zuvor im Zeitabschnitt T₁ abgeschiedenen Schicht das Zerstäuben des Targetmaterials erfolgt. Nach der Einspeisung der n₂-Gleichstrompulse in die Magnetron-Elektroden findet erneut ein Polwechsel statt, und danach werden n₁-Gleichstrompulse eingespeist. Der Prozeß wird in diesem Sinn weitergeführt, so daß im Wechsel Anzahlen von Gleichstrompulsen positiver und negativer Stromrichtung durch die Magnetron-Elektroden fließen. Die Häufigkeit der Polwechsel wird als Polwechselfrequenz bezeichnet, wobei die Polwechselfrequenz wesentlich niedriger ist als die Pulsfrequenz. In jedem Zeitabschnitt T₁ bzw. T₂, in dem mindestens eine Magnetron-Elektrode katodisch und mindestens eine Magnetron-Elektrode anodisch wirkt, wird die komplementäre elektrische Funktion jeweils durch mindestens eine andere Magnetron-Elektrode erfüllt. Die Anzahlen n₁ und n₂ der Gleichstrompulse können dabei konstant oder als Funktion der Zeit veränderlich sein.
Die Anzahlen n₁ bzw. n₂ von Gleichstrompulsen zwischen zwei Polwechseln an einer Elektrode ist größer als 1, jedoch begrenzt auf Werte unter 50 000. Die Anzahlen n₁ bzw. n₂ werden um so kleiner gewählt, je höher der spezifische elektrische Widerstand der in der anodischen Phase auf den Magnetron-Elektroden abgeschiedenen Schichten ist. Das gilt insbesondere beim reaktiven Sputtern. Damit wird gesichert, daß die Dicke dieser abgeschiedenen Schichten zwischen zwei Polwechseln so klein bleibt, daß die Impedanz der Magnetronentladungen durch diese Schichten nur unwesentlich beeinflußt wird.
Die in die Magnetronentladungen in Form von Gleichstrompulsen eingespeiste Energie wird primär als Gleichstrom oder sinusförmiger Strom zugeführt.

Die erfindungsgemäße Einrichtung zur Durchführung des Verfahrens besteht aus einer Stromversorgungseinrichtung, deren Ausgänge über eine gesteuerte elektronische Schalteinheit so mit den in einer Vakuumkammer befindlichen Magnetron-Elektroden verbunden sind, daß Gleichstrompulse mit der Pulsfrequenz f₁ bzw. f₂ generierbar sind und die Umkehr der Polarität der Gleichstrompulse mit der Polwechselfrequenz möglich ist. Die Stromversorgungseinrichtung kann demnach aus einer Gleichstromquelle und einer gesteuerten elektronischen Schalteinheit bestehen, wobei die darin integrierten elektronischen Schalter nach einem geeigneten Algorithmus derart gesteuert werden, daß am Ausgang der gesteuerten elektronischen Schalteinheit Strompulse mit der Pulsfrequenz und der Stromrichtung entsprechend des Verfahrens erzeugt werden. Vorzugsweise hat die Stromversorgungseinrichtung dabei den Charakter einer Stromquelle.
Die Stromversorgungseinrichtung kann aber auch aus einer Einrichtung zur Erzeugung eines sinusförmigen Stromes, einer Zweiwege-Gleichrichter-Schaltung und einer gesteuerten elektronischen Vollbrückenschaltung bestehen, wobei der sinusförmige Strom in der Zweiwege-Gleichrichter-Schaltung gleichgerichtet wird und die Umkehr der Polarität der Strompulse mit der Polwechselfrequenz durch die gesteuerte elektronische Vollbrückenschaltung erfolgt.

Ein Vorteil des erfindungsgemäßen Verfahrens besteht darin, daß die Wirksamkeit der Energieeinspeisung deutlich erhöht wird. Zum einen reduziert sich infolge der vergleichsweise niedrigen Polwechselfrequenz die Verlustleistung in den Bauelementen der gesteuerten elektronischen Schalteinheit, wenn Pulsgeneratoren zur Energieeinspeisung verwendet werden. Zum anderen wird die Wirksamkeit der Energieausnutzung in den Magnetronentladungen selbst erhöht. Ursache dafür ist, daß sich bisher bei der bipolaren Energieeinspeisung in Form von mittelfrequentem Wechselstrom nach jedem Polwechsel, d.h. nach jedem Puls, eine andere lokale Ladungsträgerdichteverteilung aufbauen muß, während das beim erfindungsgemäßen Verfahren nur im Takt der wesentlich niedrigeren Polwechselfrequenz der Fall ist. So lassen sich Puls-Stromversorgungen mit Stromquellencharakteristik auch mit hoher Leistung realisieren.
Ein weiterer besonderer Vorteil der Erfindung besteht darin, daß die Auswirkungen möglicherweise auftretender Bogenentladungen, insbesondere bei Energieeinspeisung mit Sinusgeneratoren hoher Leistung, wesentlich niedriger sind. Eine Ursache dafür ist, daß die Zeitdauer, in der eine Magnetron-Elektrode anodisch geschaltet ist, um den Faktor n₁ bzw. n₂ größer als bei bipolarer Energieeinspeisung ist, so daß eine wirksame Regenerierung der Oberfläche der Magnetron-Elektrode erreicht wird.

Eine vorteilhafte Ausgestaltung der Erfindung besteht darin, daß beim Einspeisen der Gleichstrompulse zwischen je zwei Pulsen die Magnetron-Elektroden untereinander kurzgeschlossen werden.
Weiterhin ist es für gleichbleibende Entladungsbedingungen vorteilhaft, die Anzahlen n₁ und n₂ der Gleichstrompulse zeitlich konstant zu halten. Bei gleicher Beschaffenheit und symmetrischer Anordnung der Magnetron-Elektroden ist es zweckmäßig, die Anzahlen n₁ und n₂ gleich zu wählen. Um eine Symmetrierung der Zerstäubungswirkung von zwei Magnetron-Elektroden zu erreichen, ist es vorteilhaft, n₁ und n₂ unterschiedlich einzustellen, da die Impedanz im allgemeinen nicht gleich ist.
Für bestimmte Algorithmen der Prozeßführung reaktiver Magnetronentladungen ist es vorteilhaft, n₁ und n₂ als Funktion der Zeit oder bestimmter Prozeßparameter zu führen. Die Anzahlen n₁ und n₂ können beispielsweise durch eine Wertetabelle vorgegeben werden oder durch in-situ-Messung eines als Führungsgröße dienenden Plasmaparameters der Magnetronentladung gewonnen werden.
Desweiteren können die Frequenzen f₁ bzw. f₂ gleich oder unterschiedlich gewählt werden, jedoch müssen sie immer im Mittelfrequenzbereich liegen.

Eine weitere vorteilhafte Ausgestaltung besteht darin, daß beim Auftreten einer Bogenentladung an einer Magnetron-Elektrode die Einspeisung weiterer Gleichstrompulse in dieser Polung unverzüglich, d.h. mit einer Zeitkonstante von maximal 5 µs abgebrochen wird, und es wird ein vorzeitiger Polwechsel durchgeführt. Damit werden nur n_{Arc}-Gleichstrompulse eingespeist, und die Anzahl n₁ bzw. n₂ wird nicht erreicht. Danach wird das erfindungsgemäße Verfahren fortgesetzt. Die Detektierung des Umschlagens der Magnetronentladung in eine Bogenentladung kann dazu in bekannter Weise, z.B. durch Überwachung der Entladungsspannung der Magnetronentladung, erfolgen. Durch besagten vorzeitigen Polwechsel werden schädliche Auswirkungen der Energie der Bogenentladung auf die Beschaffenheit der Oberfläche der Magnetron-Elektroden verhindert und die Gefahr des Auftretens weiterer Bogenentladungen drastisch herabgesetzt.

An zwei Ausführungsbeispielen wird das erfindungsgemäße Verfahren näher erläutert. Die zugehörigen Zeichnungen zeigen in
- Fig. 1: eine Einrichtung zur Durchführung des Verfahrens mit einem Gleichstromgenerator und vier Magnetron-Elektroden
- Fig. 2: eine Einrichtung zur Durchführung des Verfahrens mit einem Wechselstromgenerator und zwei Magnetron-Elektroden
- Fig. 3a: einen Stromverlauf an einer der Magnetron-Elektroden nach Fig. 1
- Fig. 3b: einen Spannungsverlauf an einer der Magnetron-Elektroden nach Fig. 2

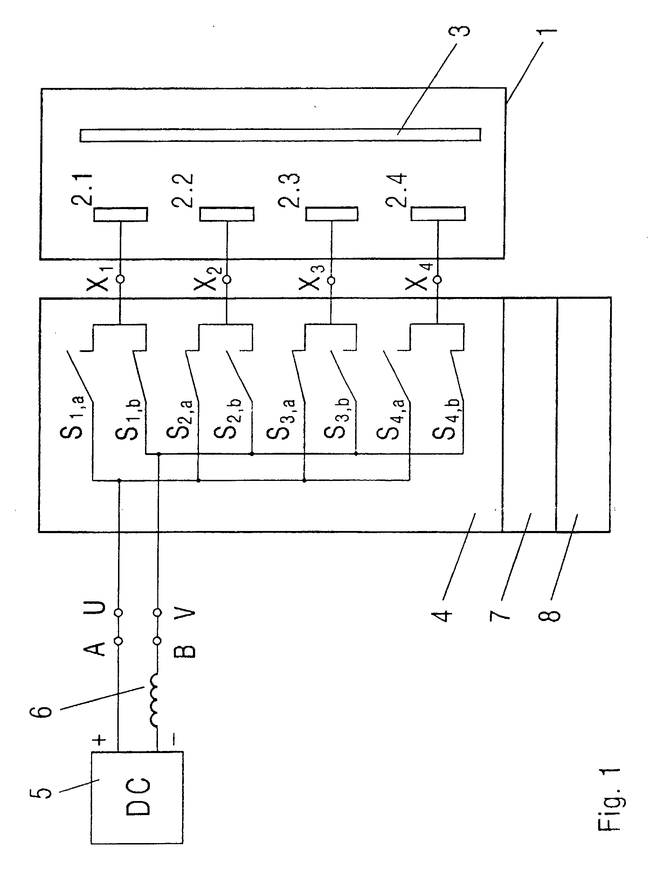

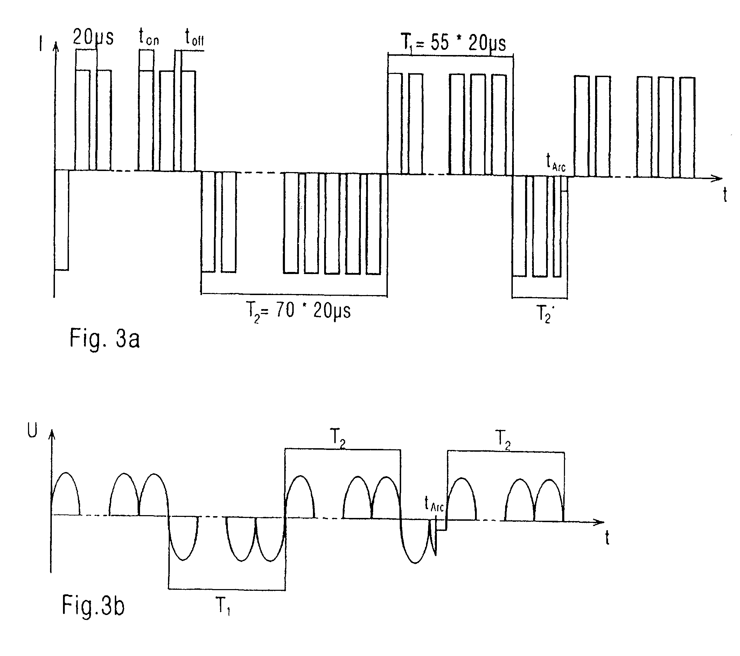

In Fig. 1 sind in einer Vakuumkammer 1 vier Magnetron-Elektroden 2.1-2.4 und ein zu beschichtendes Substrat 3 angeordnet. Die Magnetron-Elektroden 2.1-2.4 enthalten das zu sputternde Material in Form von Targets, die jeweils vom Magnetfeld der entsprechenden Magnetron-Elektrode 2.1-2.4 durchdrungen werden. Die Magnetron-Elektroden 2.1-2.4 sind über Ausgänge X₁-X₄ mit einer gesteuerten elektronischen Schalteinheit 4 verbunden. Jeder Ausgang X₁-X₄ ist mit je zwei Schaltern Sₐ und S_{b} verbunden. Die gesteuerte elektronische Schalteinheit 4 ist über die Eingänge U und V mit den Polen A und B eines Gleichstromgenerators 5 verbunden, wobei der Gleichstromgenerator 5 am Pol B eine Induktivität 6 enthält. Die Steuerung der elektronischen Schalteinheit 4 erfolgt durch die Ansteuereinheit 7. Eine Detektorschaltung 8 für Bogenentladungen ist in die Einrichtung integriert.
Im Zusammenwirken des Gleichstromgenerators 5, der Induktivität 6 und der gesteuerten elektronischen Schalteinheit 4 werden Gleichstrompulse mit konstantem Strom erzeugt. Die Einspeisung der Gleichstrompulse in die Magnetronentladung erfolgt derart, daß die Magnetron-Elektroden 2.1 und 2.4 katodisch geschalten werden, indem die Schalter S_{1,a} und S_{4,a} geöffnet und die Schalter S_{1,b} und S_{4,b} geschlossen sind. Die Magnetron-Elektroden 2.2 und 2.3 werden gleichzeitig anodisch geschalten, indem die Schalter S_{2,a} und S_{3,a} geschlossen und die Schalter S_{2,b} und S_{3,b} geöffnet sind. Die Schalter S_{1,a} und S_{4,a} werden mit einer Frequenz von 50 kHz periodisch geöffnet und geschlossen. Zwischen je zwei Gleichstrompulsen sind die Magnetron-Elektroden 2.1-2.4 und der Gleichstromgenerator 5 untereinander kurzgeschlossen.
Nach 70 Gleichstrompulsen wird ein Polwechsel durchgeführt. Dazu werden alle Schalter Sₐ und S_{b} geschlossen. Anschließend werden die Magnetron-Elektroden 2.1 und 2.4 anodisch geschalten, indem die Schalter S_{1,a} und S_{4,a} geschlossen bleiben und die Schalter S_{1,b} und S_{4,b} geöffnet werden, und die Magnetron-Elektroden 2.2 und 2.3 gleichzeitig katodisch geschalten, indem die Schalter S_{2,a} und S_{3,a} geöffnet werden und die Schalter S_{2,b} und S_{3,b} geschlossen bleiben. Es werden nunmehr die Schalter S_{2,a} und S_{3,a} mit einer Frequenz von 50 kHz periodisch geöffnet und geschlossen. Nach 55 Gleichstrompulsen wird erneut ein Polwechsel durchgeführt. Die Ansteuerung der einzelnen Schalter Sₐ und S_{b} wird in diesem Sinne fortgesetzt. Auf diese Weise wird eine Pulsfrequenz von 50 kHz mit 800 Polwechseln je Sekunde erzeugt.
Die Folge der Strompulse und die jeweilige Stromrichtung an einer Magnetron-Elektrode sind in Fig. 3a schematisch dargestellt. Nach einer Dauer T₁, in der n₁= 55 Gleichstrompulse eingespeist werden und in der die Magnetron-Elektrode anodisch geschaltet ist, werden in einem Zeitraum T₂ n₂ = 70 Gleichstrompulse entgegengesetzter Polarität eingespeist. Wird von der Detektorschaltung 8 zum Zeitpunkt t_{Arc} eine Bogenentladung erkannt, so wird mit einer Verzögerungszeit von 3 µs die Einspeisung weiterer Gleichstrompulse in alle katodisch geschalteten Magnetron-Elektroden abgebrochen und unmittelbar danach ein vorzeitiger Polwechsel durchgeführt. Somit wird im Zeitraum T*₂ nur eine Anzahl n_{Arc} von Gleichstrompulsen, die kleiner als n₂ ist, eingespeist.

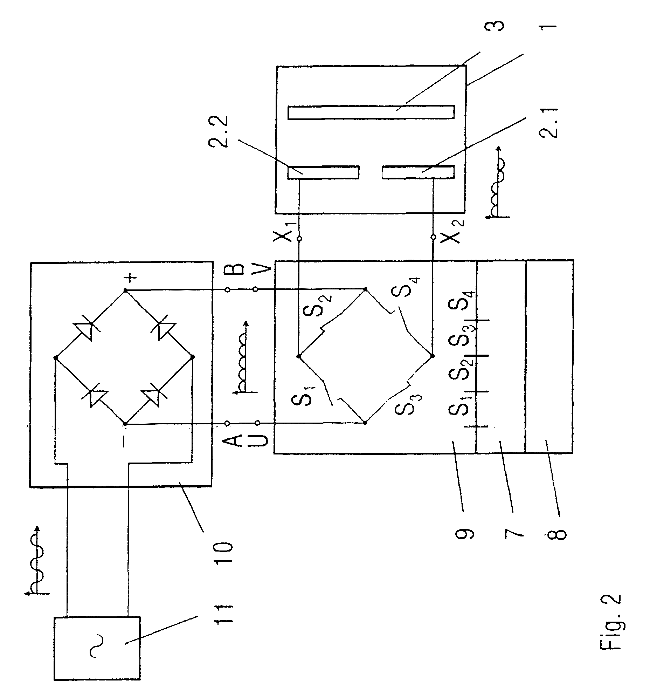

In Fig. 2 sind in einer Vakuumkammer 1 zwei Magnetron-Elektroden 2.1, 2.2 gegenüber einem Substrat 3 angeordnet. Diese enthalten Aluminiumtargets, die jeweils vom Magnetfeld der entsprechenden Magnetron-Elektrode 2.1-2.2 durchdrungen werden. Die Magnetron-Elektroden 2.1, 2.2 sind mit den Ausgängen X₁, X₂ einer gesteuerten elektronischen Vollbrückenschaltung 9 verbunden. Die Eingänge U, V der gesteuerten elektronischen Vollbrückenschaltung 9 sind mit den Ausgängen A, B einer Zweiwege-Gleichrichter-Schaltung 10 verbunden, die wiederum mit einem Wechselstromgenerator 11 verbunden ist. Zur Ansteuerung der elektronischen Vollbrückenschaltung 9 dient eine Ansteuereinheit 7. Desweiteren ist eine Detektorschaltung 8 für Bogenentladungen integriert. Der vom Wechselstromgenerator 11 erzeugte sinusförmige Strom mit einer Frequenz von 40 kHz wird in der Zweiwege-Gleichrichter-Schaltung 10 in einen pulsierenden Gleichstrom der doppelten Frequenz umgewandelt. Dem Ausgang X₁ sind die Schalter S1 und S2 zugeordnet, dem Ausgang X₂ die Schalter S3 und S4. Die Schalter S2 und S3 sind geschlossen. Damit wirkt die Magnetron-Elektrode 2.1 als Anode und die Magnetron-Elektrode 2.2 als Katode der Magnetronentladung. Der Spannungsverlauf von Gleichstrompulsen an einer Magnetron-Elektrode ist in Fig. 3b dargestellt. Nach n₁ = 500 Gleichstrompulsen werden die Schalter S2 und S3 geöffnet und gleichzeitig die Schalter S1 und S4 geschlossen. Dadurch wird eine Umkehr der Stro mrichtung der Magnetronentladung bewirkt. Nunmehr ist die Magnetron-Elektrode 2.1 Katode und die Magnetron-Elektrode 2.2 Anode der gepulsten Magnetronentladung. Nach n₂= 500 Gleichstrompulsen erfolgt erneut eine Umkehr der Stromrichtung, nachdem die Schalter S1 und S4 geöffnet und die Schalter S2 und S3 geschlossen worden sind. In der beschriebenen Weise wird die Energieeinspeisung in die Magnetronentladung mit einer Sinusfrequenz von 40 kHz und einer Pulsfrequenz von 80 kHz fortgesetzt. Dabei ändert sich die Stromrichtung der Magnetronentladung 160 mal je Sekunde, wenn keine Bogenentladungen auftreten. Die Steuerung der Schalter S1 bis S4 erfolgt durch die programmierbare Ansteuereinheit 7. Auf diese Art wird die reaktive Magnetronentladung zum Aufbringen von Aluminiumoxid auf das Substrat 3 in einem reaktiven Argon-Sauerstoff-Gasgemisch mit einer Leistung von 30 kW betrieben. Dabei bedeckt sich jede Magnetron-Elektrode zwischen je zwei Polwechseln in der anodischen Betriebsweise nur mit einer Schichtdicke, die einer mittleren Bedeckung von 0,3 Monolagen entspricht. Diese Bedeckung ist nahezu ohne Einfluß auf die Impedanz der Magnetronentladung.
Wird durch die Detektorschaltung 8 zum Zeitpunkt t_{Arc} eine Bogenentladung erkannt, so erfolgt die Betätigung der Schalter S1 bis S4, wodurch ein vorzeitiger Polwechsel durchgeführt wird, indem die Einspeisung von Gleichstrompulsen in dem gegebenen Schaltzustand abgebrochen und eine Umkehr der Stromrichtung der Magnetronentladung bewirkt wird.

## Patentansprüche

1. Verfahren zum Betreiben von Magnetronentladungen für die Vakuumbeschichtung mit mindestens zwei Magnetron-Elektroden, denen die Energie gepulst zugeführt wird, in einem Edelgas, welches vorzugsweise Anteile reaktiver Gase enthält, **dadurch gekennzeichnet, daß** mindestens eine Magnetron-Elektrode katodisch und mindestens eine Magnetron-Elektrode anodisch geschaltet wird und eine Anzahl größer 1 von Gleichstrompulsen gleicher Stromrichtung mit einer Pulsfrequenz von 10 kHz bis 150 kHz eingespeist wird, daß danach ein Polwechsel derart durchgeführt wird, daß Verbindungen zwischen den Magnetron-Elektroden und der Stromversorgung unterbrochen und mindestens eine andere Magnetron-Elektrode katodisch und mindestens eine andere Magnetron-Elektrode anodisch geschaltet werden und wiederum eine Anzahl größer 1 von Gleichstrompulsen gleicher Stromrichtung mit einer Pulsfrequenz von 10 kHz bis 150 kHz eingespeist wird, daß der Polwechsel und die Einspeisung von Gleichstrompulsen in die Magnetronentladung derart wiederholt wird, daß jede Magnetron-Elektrode im Zeitmittel gleich oft katodisch und anodisch geschaltet wird.

2. Verfahren nach Anspruch 1, **dadurch gekennzeichnet, daß** sowohl die Anzahl der negativen als auch der positiven Gleichstrompulse größer 1, vorzugsweise 100 bis 1 000, jedoch nicht mehr als 50 000, beträgt.

3. Verfahren nach Anspruch 1 und 2, **dadurch gekennzeichnet, daß** die Anzahl der negativen und positiven Gleichstrompulse gleich eingestellt und konstant gehalten wird.

4. Verfahren nach Anspruch 1 und 2, **dadurch gekennzeichnet, daß** die Anzahl der negativen und positiven Gleichstrompulse ungleich eingestellt und konstant gehalten wird.

5. Verfahren nach Anspruch 1 und 2, **dadurch gekennzeichnet, daß** die Anzahl der negativen und positiven Gleichstrompulse durch Sollwerte vorgegeben wird.

6. Verfahren nach Anspruch 1 bis 5, **dadurch gekennzeichnet, daß** beim Auftreten einer Bogenentladung auf einer Magnetron-Elektrode die Einspeisung weiterer Gleichstrompulse in die Magnetron-Elektrode in diesem Schaltzustand mit einer Zeitkonstante von maximal 5 µs, vorzugsweise 1 µs, abgebrochen und unmittelbar danach ein vorzeitiger Polwechsel durchgeführt und anschließend das Verfahren fortgesetzt wird.

7. Verfahren nach Anspruch 1 bis 6, **dadurch gekennzeichnet, daß** die in die Magnetronentladung in Form von Gleichstrompulsen eingespeiste Energie primär als Gleichstrom zugeführt wird.

8. Verfahren nach Anspruch 1 bis 6, **dadurch gekennzeichnet, daß** die in die Magnetronentladung in Form von Gleichstrompulsen eingespeiste Energie primär als sinusförmiger Strom zugeführt wird.

9. Einrichtung zur Durchführung der Verfahrens nach Anspruch 1, bestehend aus einer Vakuumkammer, in der mindestens zwei Magnetron-Elektroden angeordnet sind, einer Stromversorgungseinrichtung und einer Schalteinheit, **dadurch gekennzeichnet, daß** die Magnetron-Elektroden (2) mit den Ausgängen (X) einer gesteuerten elektronischen Schalteinheit (4) elektrisch verbunden sind, die zwischen zwei Polwechseln eine Anzahl Gleichstrompulse größer 1 gleicher Stromrichtung mit einer Pulsfrequenz von 10 kHz bis 150 kHz den Magnetron-Elektroden (2) zuführt, daß die gesteuerte elektronische Schalteinheit mit den Polen (A, B) einer Gleichstromquelle (5) elektrisch verbunden ist, und daß zur Ansteuerung der gesteuerten elektronischen Schalteinheit (4) diese mit einer Ansteuereinheit (7) verbunden ist.

10. Einrichtung zur Durchführung der Verfahrens nach Anspruch 1, bestehend aus einer Vakuumkammer, in der mindestens zwei Magnetron-Elektroden angeordnet sind, einer Stromversorgungseinrichtung und einer Schalteinheit, **dadurch gekennzeichnet, daß** die Magnetron-Elektroden (2) mit den Ausgängen (X) einer gesteuerten elektronischen Vollbrückenschaltung (9) elektrisch verbunden sind, die zwischen zwei Polwechseln eine Anzahl Gleichstrompulse größer 1 gleicher Stromrichtung mit einer Pulsfrequenz von 10 kHz bis 150 kHz den Magnetron-Elektroden (2) zuführt, daß die Eingänge (U, V) der gesteuerten elektronischen Vollbrückenschaltung (9) mit den Ausgängen (A, B) einer Zweiwege-Gleichrichter-Schaltung (10) elektrisch verbunden sind, daß die Zweiwege-Gleichrichter-Schaltung (10) mit einem Wechselstromgenerator (11) elektrisch verbunden ist, und daß zur Ansteuerung der gesteuerten elektronischen Vollbrückenschaltung (9) diese mit einer Ansteuereinheit (7) verbunden ist.

11. Einrichtung nach Anspruch 9 und 10, **dadurch gekennzeichnet, daß** eine Detektorschaltung für Bogenentladungen (8) integriert ist.

## Claims

1. Method for operating magnetron discharges for vacuum coating using at least two magnetron electrodes, to which the energy is supplied in a pulsed manner, in an inert gas which preferably contains portions of reactive gases, **characterised in that** at least one magnetron electrode is connected cathodically and at least one magnetron electrode is connected anodically and a number greater than 1 of direct current pulses of the same current direction is supplied with a pulse frequency of 10 kHz to 150 kHz, **in that** thereafter a polarity change is carried out in such a way that connections between the magnetron electrodes and the power supply are interrupted and at least one other magnetron electrode is connected cathodically and at least one other magnetron electrode is connected anodically and again a number greater than 1 of direct current pulses of the same current direction is supplied with a pulse frequency of 10 kHz to 150 kHz, **in that** the polarity change and the supply of direct current pulses to the magnetron discharge is repeated in such a way that, on a time-averaged basis, each magnetron electrode is connected equally often cathodically and anodically.

2. Method according to claim 1, **characterised in that** the number both of the negative and of the positive direct current pulses is greater than 1, preferably 100 to 1000, however not more than 50,000.

3. Method according to claims 1 and 2, **characterised in that** the number of negative and positive direct current pulses is set identical and kept constant.

4. Method according to claims 1 and 2, **characterised in that** the number of negative and positive direct current pulses is set non-identical and kept constant.

5. Method according to claims 1 and 2, **characterised in that** the number of negative and positive direct current pulses is predetermined by set values.

6. Method according to claims 1 to 5, **characterised in that** when an arc discharge occurs on a magnetron electrode, the supply of further direct current pulses to the magnetron electrode in this switching state is interrupted after a time constant of maximally 5 ms, preferably 1 ms, and immediately thereafter a premature polarity change is carried out and then the process is continued.

7. Method according to claims 1 to 6, **characterised in that** the energy supplied in the form of current pulses to the magnetron discharge is primarily supplied as direct current.

8. Method according to claims 1 to 6, **characterised in that** the energy supplied in the form of current pulses to the magnetron discharge is primarily supplied as sinusoidal current.

9. Apparatus for carrying out the method according to claim 1, comprising a vacuum chamber, in which at least two magnetron electrodes are arranged, a power supply device and a switch unit, **characterised in that** the magnetron electrodes (2) are electrically connected to the outputs (X) of a controlled electronic switch unit (4), said unit supplying to the magnetron electrodes (2), between two changes of polarity, a number of direct current pulses greater than 1 of the same current direction with a pulse frequency of 10 kHz to 150 kHz, **in that** the controlled electronic switch unit is electrically connected to the poles (A, B) of a direct current source (5), and **in that**, to control the controlled electronic switch unit (4), the latter is connected to a control unit (7).

10. Apparatus for carrying out the method according to claim 1, comprising a vacuum chamber, in which at least two magnetron electrodes are arranged, a power supply device and a switch unit, **characterised in that** the magnetron electrodes (2) are electrically connected to the outputs (X) of a controlled electronic full bridge circuit (9) which supplies to the magnetron electrodes (2), between two changes of polarity, a number of direct current pulses greater than 1 of the same current direction with a pulse frequency of 10 kHz to 150 kHz, **in that** the inputs (U,V) of the controlled electronic full bridge circuit (9) are electrically connected to the outputs (A, B) of a two-way rectifier circuit (10), **in that** the two-way rectifier circuit (10) is electrically connected to an alternating current generator (11), and **in that**, to control the controlled electronic full bridge circuit (9), the latter is connected to a control unit (7).

11. Apparatus according to claims 9 and 10, **characterised in that** a detector circuit for arc discharges (8) is integrated in it.

## Revendications

1. Procédé de mise en oeuvre de décharges de magnétron pour le revêtement sous vide à l'aide d'au moins deux électrodes de magnétron qui reçoivent de l'énergie pulsée, dans un gaz rare contenant de préférence des parties de gaz réactif,
**caractérisé en ce qu'**
au moins une électrode de magnétron est branchée comme cathode et au moins une électrode de magnétron est branchée comme anode,
on injecte un nombre supérieur à l'unité d'impulsions de courant continu, de même sens de passage du courant, avec une fréquence impulsionnelle comprise entre 10 kHz et 150 kHz, puis on effectue un changement de polarité,
on coupe les liaisons entre les électrodes de magnétron et l'alimentation en courant et on branche au moins une autre électrode de magnétron comme cathode et au moins une autre électrode de magnétron comme anode, et on injecte de nouveau un nombre supérieur à l'unité d'impulsions de courant continu, de même sens de passage du courant, avec une fréquence impulsionnelle comprise entre 10 kHz et 150 kHz,
on répète le changement de polarité et l'injection d'impulsions de courant continu dans les décharges de magnétron, chaque électrode de magnétron étant branchée en moyenne dans le temps, de façon égale comme cathode et comme anode.

2. Procédé selon la revendication 1,
**caractérisé en ce qu'**
à la fois le nombre des impulsions de courant continu, négatives, que celui des impulsions positives est supérieur à 1, de préférence compris entre 100 et 1 000, et toutefois inférieur à 50 000.

3. Procédé selon les revendications 1 et 2,
**caractérisé en ce que**
le nombre d'impulsions de courant continu négatives et positives est réglé de façon égale et il est maintenu constant.

4. Procédé selon les revendications 1 et 2,
**caractérisé en ce que**
le nombre des impulsions de courant continu négatives et celui d'impulsions positives sont réglés de manière inégale et ils sont maintenus constant.

5. Procédé selon les revendications 1 et 2,
**caractérisé en ce que**
le nombre des impulsions de courant continu négatives et celui d'impulsions positives sont prédéfinis par des valeurs de consigne.

6. Procédé selon les revendications 1 à 5,
**caractérisé en ce que**
lorsque se produit une décharge par arc électrique sur une électrode de magnétron, on coupe l'injection d'autres impulsions de courant continu dans l'électrode de magnétron, dans cet état de commutation, avec une constante de temps maximale de 5 µs et de préférence 1 µs et immédiatement ensuite on effectue par anticipation, un changement de polarité et ensuite on poursuit le procédé.

7. Procédé selon les revendications 1 à 6,
**caractérisé en ce qu'**
on fournit de l'énergie primaire comme courant continu, à la décharge de magnétron sous la forme d'impulsions de courant continu.

8. Procédé selon les revendications 1 à 6,
**caractérisé en ce qu'**
on fournit à la décharge de magnétron, de l'énergie primaire comme courant de forme sinusoïdale injecté à l'état d'impulsions de courant continu.

9. Installation pour la mise en oeuvre du procédé selon la revendication 1, composée d'une chambre à vide avec au moins deux électrodes de magnétron, une installation d'alimentation en courant et une unité de commutation,
**caractérisée en ce que**
les électrodes de magnétron (2) sont reliées électriquement aux sorties (X) d'une unité de commutation électronique commandée (4), fournissant entre deux alternances de polarité, un nombre d'impulsions de courant continu supérieur à 1, dans le même sens de passage du courant, avec une fréquence impulsionnelle de 10 kHz-150 kHz aux électrodes de magnétron (2),
l'unité de commutation électronique commandée est reliée électriquement aux pôles (A, B) d'une source de courant continu (5) et une unité de commande (7) est reliée à l'unité de commutation électronique (4) pour la commander.

10. Installation pour la mise en oeuvre du procédé selon la revendication 1, composée d'une chambre à vide avec au moins deux électrodes de magnétron, une installation d'alimentation en courant et une unité de commutation,
**caractérisée en ce que**
les électrodes de magnétron (2) sont reliées aux sorties (X) d'un montage en pont complet, (9), à commande électronique, fournissant entre deux alternances de polarité, un nombre d'impulsions de courant continu supérieur à l'unité, de même sens de passage du courant avec une fréquence d'impulsions comprise entre 10 kHz et 150 kHz aux électrodes de magnétron (2),
les entrées (U, V) du montage en pont complet, électronique, commandées (9) sont reliées aux sorties (A, B) d'un redresseur à deux branches (10),
le redresseur à deux branches (10) étant relié à un générateur de courant alternatif (11) et
le pont complet électronique commandé (9) est relié à cette unité de commande (7) pour être commandé.

11. Installation selon les revendications 9 et 10,
**caractérisée en ce qu'**
elle comprend un circuit de détecteur intégré de décharges par arcs électriques (8).
